# EUROPEAN PATENT APPLICATION

(11) **EP 0 955 393 A1**
(43) Date of publication of application: **10.11.1999**
(21) Application number: 97936894.1
(22) Date of filing: 12.08.1997
(51) Int. Cl.: C23C 16/44

(54) **METHOD OF MULTIFUNCTIONAL SURFACE TREATMENT, AND DEVICE FOR IMPLEMENTING SAME**

(30) Priority: 24.01.1997 RU 97100692
(71) Applicant: Ryabkov, Danila Vitalievich, Moscow, 121609 (RU)
(72) Inventor: Ryabkov, Danila Vitalievich, Moscow, 121609 (RU)
(74) Representative: Hoarton, Lloyd Douglas Charles
(86) International application number: RU9700253
(87) International publication number: WO9832892

(57) **Abstract**

A method of multifunctional cleaning of surfaces includes the steps of cleaning and application of a coating by plasma formed in the object's near-surface zone by way of delivering a steam-gas mixture onto the treated surface via the working surface of an anode device having through openings.

An apparatus for treatment of surfaces comprises a current source and a chamber, wherein disposed are a treated object, a cathode and an anode device having through openings in the working surface. The salient feature of the apparatus is the presence of a reactor disposed in the anode device, a vessel for electrolyte disposed outside the chamber and coupled to the anode device. The invention allows to improve the surface cleaning quality, provide durability of surfaces and increase the rate of a process.

## Description

### Field of the Invention

The invention relates to metallurgy, particularly to electrochemical treatment of metallic surfaces and other current-carrying surfaces. More particularly the invention relates to techniques and apparatuses for multi-functional treatment of surfaces using electric-discharge plasma.

### Background of the Invention

Known are methods of cleaning metallic surfaces from various contaminants, as described in Mechanical Engineer's Reference Book, volume P.M., Mashizdat publishers, 1951, at pages 385-387 and 547, which methods provide for exposing the surface of a treated object to action of a dispersed material delivered by a compressed air flow, exposing to a thermal treatment with oxygen-acetylene burners, releasing and subsequent removing of a contaminating substance off a treated object.

Disadvantages of the known solution are a considerable pollution of work places, noise, dust-laden ambient air, etc.

Known is a method of application of coatings by electrodeposition of a metal, and an apparatus for implementation thereof, wherein an object is disposed in a vessel having electrolyte between electrodes connected to the opposite poles of a direct current source. To generate an arc discharge, the cathode is periodically brought in contact with a treated object, then resetting the cathode. As a result, when a gas discharge impinges upon a surface, a coating having the material composition coinciding with that of the anode material is formed (see USSR auth. cert. No. 1544844, cl. C 25 D 5/18, 1988).

Disadvantages of the above-discussed solution are periodicity and a considerable duration of the coating application process, and unevenness of the coating thickness.

As regards the technical essence and the attained result, a method and apparatus for treatment of surfaces described in GB A 2083077, Standard Telephones and Cables Ltd., 17 03 82, C 25 D 5/02, are the most proximate to the proposed invention.

Said known method comprises the steps of disposing a treated object in a chamber with an electrolyte, connecting the object to a cathode and applying a coating by the electrolyte jet via an anode having through openings, using the direct electric current.

The known apparatus comprises a current source and a chamber wherein a treated object, a cathode and anode having through openings are disposed.

Disadvantages of these known method and apparatus are a considerable duration of the process, unevenness of the coating thickness, and the difficulty of taking into account numerous factors determining the process parameters, which difficulty is attendant upon the variance, in the course of coating deposition process, of composition of the substances constituting an electrolyte. Furthermore, this known solution does not provide for cleaning the treated surface from contaminants, and combination of the cleaning with the coating application process.

### Disclosure of the Invention

The invention is based on the goal to develop a method and apparatus of multifunctional treatment of surfaces, whereby duration of the coating application process will be more brief, a required and even thickness of the coating surface will be provided, and the possibility of a ready changing of the electrolyte composition substances without suspending the process of coating application and cleaning of the treated surface from contaminants will be provided.

The above-specified goal is to be attained through that in a method of multifunctional treatment of surfaces, including the steps of disposing a treated object in a chamber, connecting said object to the negative pole of a current source, and applying a coating onto the object surface by a conductive medium flow supplied through openings in the anode device working surface, connecting said object to the positive pole of the current source, - according to this invention cleaning is carried out and a coating is applied by a plasma having the reducing properties, which plasma is formed in the object's near-surface zone, and the electrolyte converted into a steam-gas mixture using the anode device is used as the conductive medium.

The optimum conditions to attain the set goal, with respect to the method object of this invention, are as follows:
■ for cleaning the treated object surface, as the anode device working surface material used is the material of a treated object or an electrochemically inert material;
■ treatment is carried out in a constant unipolar pulsating electric field;
■ for cleaning from oxide layers and films, used is a plasma having the reducing properties;
■ cleaning and coating application are carried out simultaneously;
■ coating is applied to a portion of the treated object surface;
■ coating is applied to the entire surface of the treated object surface;
■ a multilayer coating is applied;
■ a portion of the surface is subjected to cleaning, and onto the other portion thereof a coating is applied;
■ to a portion of a surface a coating of one type is applied, and to the other portion thereof applied is a coating of the other type different from the first one;
■ as the electrolyte, aqueous solutions of salts or salt melts, or their mixtures with gases are used.

The set goal is also reached through that an apparatus for a multifunctional treatment of surfaces, comprising a current source and a chamber, wherein disposed are a treated object, a cathode and an anode device having through openings in its working surface, in accordance with the invention is provided with a reactor for producing a steam-gas mixture of an electrolyte, which reactor is disposed in the anode device, and also provided with a vessel for electrolyte, which vessel is disposed outside the chamber and coupled to the reactor via an inlet manifold, and coupled to the chamber lower portion via an outlet manifold, and provided with a system for fixing a treated object and the anode device working surface relative to one another.

The optimum conditions for attaining the above-mentioned goal with regard to the apparatus portion of the invention are as follows:
■ the lower portion of the chamber is implemented in the form a vessel for collecting an electrolyte;
■ the apparatus is provided with a filter for purifying the spent electrolyte, which filter is mounted on the outlet manifold between the chamber bottom and the electrolyte vessel;
■ as the electrolyte used are aqueous solutions of salts and salt melts, or their mixtures with gases;
■ the system for fixing a treated object and the anode device working surface relative to one another is implemented in the form of pairs of rollers or balls;
■ the anode device working surface is disposed equidistantly with respect to the treated surface;
■ the anode device working surface is implemented in the form of a mesh or a plate having openings;
■ the anode device working surface is implemented of the material wherewith a coating is applied to the treated surface;
■ the anode device working surface is shaped such that it replicates the treated surface shape;
■ the apparatus is equipped with an evaporator and nozzles-dispersers disposed within the anode device reactor for producing steam or steam-gas mixture of an electrolyte;
■ the apparatus is equipped with a temperature control means in the anode device reactor, which temperature control means is implemented in the form of a temperature sensor and controller;
■ the apparatus is equipped with a heater and cooler disposed in the electrolyte vessel;
■ the apparatus is equipped with a temperature control means in the electrolyte vessel, which means is implemented in the form of a temperature sensor and controller;
■ the apparatus is equipped with a pump mounted on the inlet manifold between the electrolyte vessel and the anode device;
■ the apparatus is equipped with an electrolyte flow rate controller positioned between the pump and the anode device;
■ the apparatus is equipped with an additional anode device disposed in parallel to the first anode device, a treated object being positioned between them;
■ the apparatus has several anode devices.

The invention is distinguished from the most proximate analogue by, and the claimed technical solution is rendered as complying with the 〈〈Novelty〉〉 condition owing to that the cleaning and coating are carried out using plasma formed in the near-surface zone of an object, that as a conductive medium used is an electrolyte converted into a steam-gas mixture by an anode device, as well as that the anode device is provided with a reactor for producing the electrolyte steam-gas mixture, which reactor is disposed in the anode device, with an electrolyte vessel disposed outside a chamber and coupled to the reactor via an inlet manifold, and coupled to the lower portion of the chamber via an outlet manifold, and with a system of fixing a treated object and the anode device working surface face relative to one another.

The claimed group of inventions is distinctive with regard to the known ones in that application of a coating by plasma formed in the near-surface zone of an object reduces duration of the process, provides a necessary and even thickness of a coating having an high quality.

The electrolyte vessel disposed outside the chamber allows to change the electrolyte substances composition quickly in the course of the process and simultaneously clean the treated surface from contaminants. All these circumstances, in the applicant's opinion, allow to assert that this invention has a novel set of features and that the claimed technical solution complies with the 〈〈Inventive step〉〉 criterion.

Application of the proposed technique and design thereof provide both cleaning of a surface from various contaminants, and obtaining the quality coatings on objects of a wide usage and categories, permits to treat both small-sized and long-dimension articles, apply a coating of one type to one portion of an article, and apply to the other part thereof a coating of the type other than the first type. All the foregoing attests to the compliance of the above-discussed technical solution with the 〈〈Industrial applicability〉〉 criterion.

### Embodiment of the Invention

A flow of a conductive medium is supplied to a treatment zone, as the conductive medium used is a steam-gas mixture containing charged particles or ions of the coating material (hereinafter referred to as the 〈〈operating agent〉〉). The operating agent is produced by way of passing an electrolyte through an anode device. In a multifunctional surface treatment apparatus a number of anode devices can be installed. The anode device consists of a **reactor**, wherein an electrolyte is converted into a steam-gas mixture, and a working surface having openings, through which openings the steam-gas mixture is delivered onto the treated surface. The openings can have different shapes depending on the treatment parameters and conditions. A material of which the anode device working surface is manufactured is selected depending on the treatment purposes, i.e. when a coating is applied, usually used is the working surface of the material that is to coat the article surface, and in the case of cleaning of the article surface used is the working surface of the material having the same chemical composition as that of the treated article surface.

A value of the voltage supplied to the anode device is established on the basis of the condition causing a plasma layer having the reducing properties to emerge in the treated article near-surface zone; and the distance between the anode device working surface face and the treated surface is determined basing on the condition of the minimum energy spent for the article surface treatment and of the plasma layer steadiness. The anode device working surface shape preferably replicates that of the treated surface, i.e. the distance between the treated surface and the anode device working surface must be approximately equal over the entire treatment zone area. As a result of action effected by the plasma layer having the reducing properties upon the treated surface, various contaminants are removed therefrom, and the oxides of the material existing on the surface are reduced. Thus the cleaning of the surface of articles from different contaminants is implemented.

The positively charged particles (ions), released from the anode according to the electrochemical dissolution rules and transferred by the operating agent, form a coating on the treated surface by action of the plasma layer. Further, the use of the positively charged particles (ions) of the same chemical composition as the treated surface results in formation of a layer of the same material, but said layer is more corrosion-resistant and retains the adhesion properties and the surface activity during a longer period.

However, a coating can be done by another method. A metal oxide intended for coating of a surface is applied onto the article surface by any known method, e.g. by spraying such oxide or fixing it on the treated surface with a binder, and then the treatment is carried out in the way set forth above. The applied oxide layer is reduced, and as a result a metallic coating is formed upon the surface.

For cleaning the article surface or for applying a coating thereon, the anode device working surface of inert materials, i.e. of a material slightly soluble or non-soluble by the electrochemical method (an inert material) such as tungsten, carbon etc., can be used. In coating, as a source of the positively charged particles (ions), an electrolyte having a soluble salt or a hydroxide of a metal by which metal the treated surface is to be coated can be used, the working surface of an inert material or the same material as the required coating being employed.

For the purpose to provide a failure-free and steady process mode, used is a system for fixing a treated object relative to the anode device working surface, or vice versa - fixing said surface relative to a treated object. Said fixing can be realised by different methods, for instance using a roller pair system, wherein the rollers clamp and/or pull taut the treated object. Such system can be used in treating a sheet, strip or other long-dimension or continuous articles. For treatment of the inner and outer surfaces of pipes and other hollow articles using a moving anode device and a stationary treated object, can be used, for example, a fixing system implemented using balls or rollers rotatable and protruding from the anode device, which balls or rollers are positioned on said means such that their projecting portions will roll upon the treated object surface. Thus in this case the anode device is fixed relative to the treated object. The mandatory condition to be met in such fixing system is insulation of the balls or rollers, mounted on the anode device, against the voltage and flow of electric current therethrough. i.e. it is necessary to use balls or rollers manufactured of a non-conductive material or coated by such material.

The invention is further explained with reference to the accompanying drawings, wherein:
Fig. 1 shows a diagram of an apparatus for one-side multifunctional treatment of a metallic strip.
Fig. 2 shows a diagram of an apparatus for two-side treatment, with the vertical positioning of a treated object.
Fig. 3 shows an arrangement diagram and a system for fixing anode devices relative to a treated object in treating the outer and inner surfaces of hollow articles.

An apparatus for multifunctional treatment of surfaces consists of chamber 1, wherein positioned are treated object 2 and anode device 3; direct current source 4, to the positive pole of which source connected is the anode device, and to its negative pole connected is a treated object; and electrolyte vessel 5. The apparatus also has a system for fixing treated object 2, which system is implemented as roller pairs 6 which can be used also for longitudinal movement of treated object 2.

Anode device 3 has reactor 7 and working surface 8. The multifunctional surface treatment apparatus is provided with inlet manifold 9 and outlet manifold 10 for delivering the electrolyte to anode device 3 and also for removing the electrolyte from chamber 1. The electrolyte flow rate is adjusted by controller 11. Nozzles-dispersers 12 can be installed in anode device 3 for the purpose of even distribution of the electrolyte flow. Electrolyte temperature in vessel 5 is adjusted using temperature sensor 13, controller 14 and heater 15. Temperature adjustment in reactor 7 of anode device 3 is done by temperature sensor 16 and controller 17.

The electrolyte from the vessel is delivered by pump 18 mounted on inlet manifold 9. The anode device working surface has openings 19, or is implemented in the form of a mesh. A filter is mounted on outlet manifold 10 to purify the spent electrolyte coming from chamber 1 to vessel 5.

The invention is embodied as follows.

Treated object 2 is placed in chamber 1 or it is drawn therethrough (when long-dimension articles are treated). Upon entering the chamber, object 2 is earthed and/or connected to the negative pole of current source 4. Further, treated object 2 is fixed by roller pairs 6 relative to working surface 8.

Anode means 3 is installed at the surface of treated object 2 and connected to the positive pole of current source 4. Then to anode device 3, by the pump, supplied is the electrolyte from vessel 5, which electrolyte is converted into a steam-gas mixture by reactor 7, and the so produced operating agent through openings 19 in anode 8 is delivered onto the surface of treated object 2.

The distance between working surface 8 and the surface of treated object 2 is determined on the basis of the minimum energy to be spent for treating the article surface, a value of electric potential supplied to anode device 8 is based on the condition that a temporally steady plasma layer having the reducing properties in the near-surface zone of treated object 2 will be created.

As a result of the thermal, electromagnetic and chemical action effected by the plasma layer having the reducing properties, off the surface of treated object 2 various contaminants (fat, oil, etc.) are removed, the material oxides present on the surface of object 2 are reduced, and on the surface a layer of a coating of a required material that was dissolved in the form of a salt or hydroxide, or owing to the electrochemical dissolution of working surface 8, is formed. In case when working surface 8 of an inert material is used, the surface of treated object 2 is cleaned and activated, and if into the electrolyte the additives of salts or hydroxides were introduced, then on the surface of object 2 formed is a coating of the material that had been dissolved in the form of a salt or hydroxide is formed. In the case when working surface 8 of a non-inert material, the chemical composition of which material coincides with the material of the surface of treated object 2, is used, on the latter a layer of the same material is formed, and such resulting material is more corrosion-resistant and retains the surface activity for a longer period, i.e. is more pure chemically.

The spent electrolyte from chamber 1 is removed by gravity or using a pump (not shown) through outlet manifold 10 into vessel 5 via filter 20, wherein the electrolyte is purified from mechanical and other contaminants.

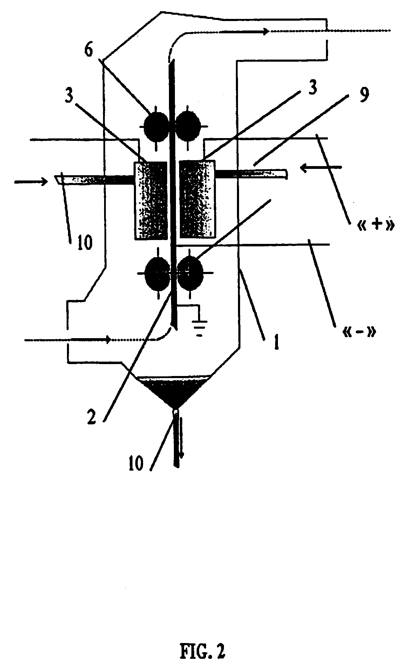

In the two-side treatment (Fig. 2), object 2 is positioned vertically, and the treatment is carried out using anode devices 3 disposed at either side of treated object 2. Otherwise the treatment is carried out in the same manner as the one-side treatment.

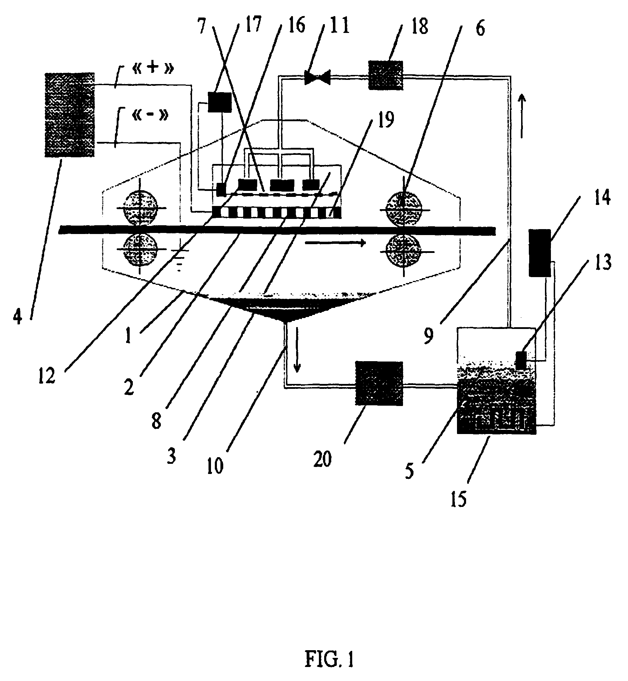

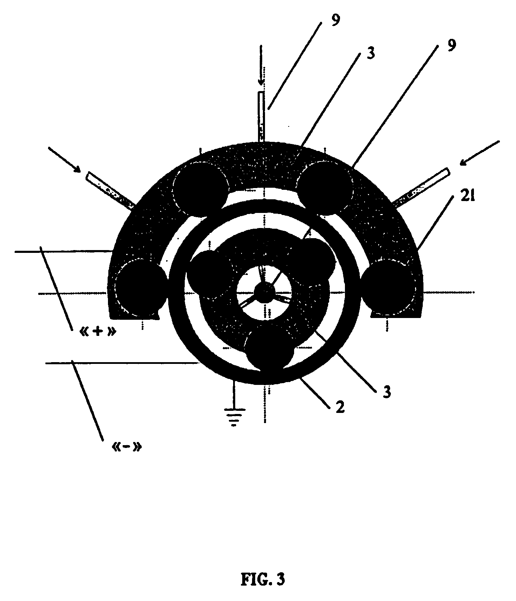

Treatment of the outer and inner surfaces of hollow articles (Fig. 3) can be carried out in the same manner as the one-side and two-side treatments, except that treated object 2 usually does not move translationally during the treatment, but it is anode devices 3 disposed outside and inside treated object 2 that make the translational movements. For treating the inner surface of object 2, anode device 3 is disposed within said object. In case of using several anode devices 3 which simultaneously treat the entire outer and inner surfaces of object 2, said devices can be stationary. In the case of treatment of rotating bodies (pipes, etc.), treated object 2 and/or anode devices 3 can do rotational motions about axis of the treated object 2. Anode devices 3 shown in Fig. 3 also differ from these shown in Fig. 1 and 2 in that thereon is mounted a system for fixing relative to the surface of treated object 2, which system is implemented using the protruding and rotatable balls or rollers 21, which balls and rollers by their protruding portion roll upon the surface of treated object 2.

### Examples of Realisation of the Invention

### Example 1.

A surface has been prepared for coating (surface cleaning) in the above-described apparatus.

In the chamber, a steel strip having a layer of FeO black scale and fat-oil contamination on the surface was positioned. The steel strip was connected to the current source negative pole. The distance between the anode device working surface arid the treated surface was determined to be 10 mm. The anode device working surface was made of the same steel as the treated strip. 10-percent solution of Na₂CO₃ was used as the electrolyte. Flow rate of the electrolyte delivered to the anode device was determined to be 0.35 l/min. The treatment zone area was 20 cm³. Voltage value at the power supply source output was 175 V.

Under the above-mentioned conditions, in the near-surface zone of the treated object a plasma layer treating the surface is formed.

As a result of the treatment the FeO black scale on the steel strip surface was converted to the metal state Fe; fat-oil contaminants and other contaminants were removed.

Thus, the surface of the steel strip was cleaned and activated, i.e. prepared for subsequent application of a coating by any conventional method.

### Example 2.

A copper coating was applied using the same apparatus.

In the chamber an uncleaned steel strip connected to the power supply source negative pole was positioned. The distance between the anode device working surface and the treated strip surface was set at 10 mm. The anode device working surface was of metallic copper Cu. 10-percent solution of Na₂CO₃ was used as the electrolyte. The electrolyte flow rate delivered to the anode device was 0.35 l/min. The treatment zone area was 20 cm². Voltage value at the power supply source output was 180 V.

Under the above-mentioned conditions formed is a plasma layer in the steel strip treatment near-surface zone, with which layer the surface is further treated.

As a result of the treatment, a steel strip having a copper coating layer on the treated surface 10 mcm thick was obtained. The steel strip surface beneath the copper coating layer contained no contaminants, including rust Fe₂O₃ and Fe₃O₄ and black scale FeO.

### Industrial Applicability

The use of the invention will allow to lower consumption of the materials used in the treatment process, and also avoid the metal losses occurring in treatment, owing to reduction of the article's surface oxides, instead of the usual removal by various methods and evacuation thereof to the slime. The proposed method also allows to decrease the energy costs owing to the circumstance that application of a coating is performed simultaneously with the surface cleaning, i. e. the method allows to eliminate the surface cleaning as a technological step prior to application of coatings. Further, the possibility to reduce the amount of hazardous vapours in the course of the treatment, to render the process automatic and thereby improve the labour conditions has been realised. These considerations allow to class this proposal with the category of the nature-conserving and resources-saving, ensuring an high level of environmental safety inventions.

## Claims

1. A method of multifunctional treatment of surfaces, comprising the steps of positioning a treated object in a chamber, connecting said object to the negative pole of a current source, and applying a coating onto the object surface by a conductive medium flow, said medium being delivered via openings in the working surface of an anode device connected to the positive pole of the current source, ***characterised*** in that cleaning is carried out and a coating is applied by a plasma having the reducing properties, which plasma is formed in the near-surface zone of an object, and an electrolyte converted into a steam-gas mixture using the anode device is used as the conductive medium.

2. The method as claimed in claim 1, characterised in that for cleaning the treated object surface, the material of the treated object or an electrochemically inert material are used as the material of the anode device working surface.

3. The method as claimed in claim 1, characterised in that the treatment is carried out in a constant or unipolar pulsating electric field.

4. The method as claimed in claim 2, characterised in that for cleaning from oxide layers and films used is a plasma having the reducing properties.

5. The method as claimed in claim 1, characterised in that the cleaning and coating application are carried out simultaneously.

6. The method as claimed in claim 1, characterised in that a coating is applied to a portion of the treated object surface.

7. The method as claimed in claim 1, characterised in that a coating is applied to the entire surface of the treated object.

8. The method as claimed in any one of claims 6, 7, characterised in that a multilayer coating is applied.

9. The method as claimed in claim 1, characterised in that a portion of the treated surface is subjected to cleaning, and to the other portion of the surface a coating is applied.

10. The method as claimed in claim 8, characterised in that to a portion of the surface applied is a coating of one type, and to the other portion thereof a coating of other than the first type is applied.

11. The method as claimed in claim 1, characterised in that aqueous solutions of salt or melts of salts, or their mixtures with gases are used as the electrolyte.

12. An apparatus for multifunctional treatment of surfaces, comprising a current source and a chamber, wherein disposed are a treated object, a cathode and an anode device having through openings in the working surface, ***characterised*** in that said apparatus is provided with a reactor for producing a steam-gas mixture of an electrolyte, which reactor is disposed in the anode device, a vessel for the electrolyte disposed outside the chamber and connected to the anode device via an inlet manifold, and connected to the lower portion of the chamber via an outlet manifold, and with a fixing system for fixing a treated object and the anode device working surface relative to one another.

13. The apparatus according to claim 12, characterised in that the lower portion of the chamber is implemented in the form of a vessel for collecting the spent electrolyte.

14. The apparatus according to claim 12, characterised in being provided with a filter for purifying the spent electrolyte, which filter is mounted on the outlet manifold between the chamber lower portion and the electrolyte vessel.

15. The apparatus according to claim 12, characterised in that the system for fixing a treated object and the anode device working surface relative to one another is implemented in the form of pairs of rollers or balls.

16. The apparatus according to claim 12, characterised in that the anode device working surface is disposed equidistantly relative to the treated surface.

17. The apparatus according to claim 12, characterised in that the anode device working surface is implemented in the form of a mesh or plate having openings.

18. The apparatus according to claim 12, characterised in that the anode device working surface is made of the material wherewith a coating is applied to the treated surface.

19. The apparatus according to claim 12, characterised in that the anode device working surface is made of an electrochemically inert material.

20. The apparatus according to claim 12, characterised in that the anode device working surface is shaped as replicating the shape of the treated surface.

21. The apparatus according to claim 12, characterised in being provided with an evaporator and nozzles-dispersers disposed in the anode device reactor.

22. The apparatus according to claim 12, characterised in being provided with a temperature control means in the anode device reactor, which means is implemented in the form of a temperature sensor and controller.

23. The apparatus according to claim 12, characterised in being provided with a heater and a cooler disposed in the electrolyte vessel.

24. The apparatus according to claim 12, characterised in being provided with means for controlling temperature in the electrolyte vessel, which means is implemented in the form of a temperature sensor and controller.

25. The apparatus according to claim 12, characterised in being provided with a pump mounted on the inlet manifold between the electrolyte vessel and the anode device.

26. The apparatus according to claim 12, characterised in being provided with an electrolyte flow rate controller positioned between the pump and the anode device.

27. The apparatus according to claim 12, characterised in being provided with an additional anode device disposed parallel with the first device, a treated object being positioned between them.

28. The apparatus according to claim 12, characterised in having a number of anode devices.
